Europäisches Patentamt

European Patent Office

Office européen des brevets

(19)

(11) EP 0 499 554 B1

(12) FASCICULE DE BREVET EUROPEEN

(45) Date de publication et mention
de la délivrance du brevet:
**23.04.1997 Bulletin 1997/17**

(51) Int Cl.6: **H03F 3/45**

(21) Numéro de dépôt: **92420045.4**

(22) Date de dépôt: **10.02.1992**

(54) **Amplificateur opérationnel à transconductance à grande excursion de mode commun**

Transkonduktanzoperationsverstärker mit grossem Gleichtaktpegel

Transconductance operational amplifier with great common mode swing

(84) Etats contractants désignés:
**DE FR GB IT**

(30) Priorité: **12.02.1991 FR 9101974**

(43) Date de publication de la demande:
**19.08.1992 Bulletin 1992/34**

(73) Titulaire: **SGS-THOMSON MICROELECTRONICS S.A.**
**94250 Gentilly (FR)**

(72) Inventeur: **Ryat, Marc**
**F-38000 Grenoble (FR)**

(74) Mandataire: **de Beaumont, Michel**
**1bis, rue Champollion**
**38000 Grenoble (FR)**

(56) Documents cités:
**EP-A- 0 159 757**     **US-A- 3 497 824**
**US-A- 4 574 250**     **US-A- 4 887 048**

**Description**

La présente invention concerne les amplificateurs opérationnels à transconductance, et en particulier de tels amplificateurs à grande excursion de mode commun (on appelle mode commun la moyenne des tensions d'entrée).

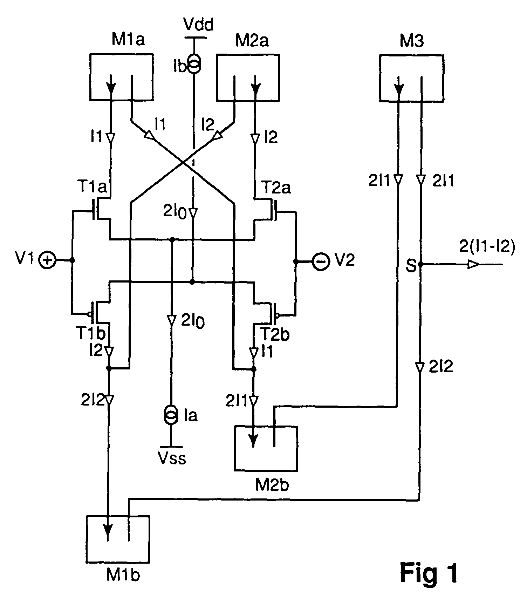

La figure 1 illustre un schéma simplifié d'un amplificateur opérationnel à transconductance à grande excursion de mode commun, semblable à celui décrit dans la demande de brevet européen 0 159 757. Cet amplificateur comprend un étage d'entrée à deux amplificateurs différentiels complémentaires à transistors MOS.

Le premier amplificateur différentiel comprend deux transistors MOS à canal N T1a et T2a dont les grilles sont respectivement reliées à une entrée non inverseuse (+) et à une entrée inverseuse (-). Les sources de ces transistors sont reliées entre elles et sont chargées par une source de courant Ia reliée à une tension d'alimentation négative Vss et drainant un courant $2I_0$.

Le deuxième amplificateur différentiel comprend deux transistors MOS à canal P T1b et T2b dont les grilles sont respectivement reliées à l'entrée (+) et à l'entrée (-). Les sources de ces transistors sont reliées entre elles et sont chargées par une source de courant Ib reliée à une tension d'alimentation positive Vdd et délivrant un courant $2I_0$.

Les drains des transistors T1a et T2a sont respectivement reliés à l'entrée d'un miroir de courant M1a et à l'entrée d'un miroir de courant M2a. Un miroir de courant est un circuit à deux voies qui recopie sur sa deuxième voie, appelée ici sortie, le courant présent sur une première voie, appelée ici entrée et marquée par une flèche. Les sorties des miroirs de courant M1a et M2a sont respectivement reliées au drain du transistor T2b et au drain du transistor T1b. Le drain du transistor T2b est relié à l'entrée d'un miroir de courant M2b dont la sortie est reliée à l'entrée d'un miroir de courant M3. Le drain du transistor T1b est relié à l'entrée d'un miroir de courant M1b. Les sorties des miroirs de courant M3 et M1b sont reliées l'une à l'autre et constituent la sortie S de l'amplificateur.

Le fonctionnement normal de ce circuit est le suivant.

En l'absence de signal différentiel entre les entrées (+) et (-), le courant dans les drains de chacun des transistors T1a, T2a, T1b, T2b est égal à un courant de repos $I_0$ égal à la moitié du courant $2I_0$ fixé par les sources de courant Ia et Ib.

Lorsqu'on applique une tension V1 à l'entrée (+) et une tension V2 à l'entrée (-), il s'établit un courant I1 dans les drains de chacun des transistors T1a et T2b et un courant I2 dans les drains de chacun des transistors T2a et T1b ; les courants I1 et I2 répondant aux relations suivantes :

$$I1 + I2 = 2I_0, \text{ et}$$

$$I1 - I2 = (V1 - V2)g_m(I_0)$$

où $g_m(I_0)$ désigne la transconductance de chacun des transistors pour un courant de drain de repos égal à $I_0$.

Le courant de drain I1 du transistor T1a se retrouve en sortie du miroir de courant M1a et vient s'ajouter au courant de drain I1 du transistor T2b, et l'entrée du miroir de courant M2b reçoit ainsi un courant 2I1. De même, le courant de drain I2 du transistor T2a se retrouve en sortie du miroir M2a et vient s'ajouter au courant de drain I2 du transistor T1b, et le miroir M1b reçoit ainsi à son entrée un courant 2I2. Ainsi, le miroir M3, dont l'entrée reçoit le courant 2I1 de sortie du miroir M2b, délivre à la sortie S un courant 2I1 et le miroir M1b draine de la sortie S un courant 2I2. La sortie S de l'amplificateur fournit donc un courant Is tel que :

$$Is = 2(I1 - I2) = 2(V1 - V2)g_m(I_0).$$

La transconductance de l'amplificateur est alors égale à $2g_m(I_0)$.

Lorsque l'un des courants I1 ou I2 est nul, l'autre est égal au courant fourni par les sources Ia et Ib. Alors, le courant de sortie Is est maximal et vaut ici $4I_0$. Ce courant détermine la vitesse maximale de charge de capacités parasites présentes dans l'amplificateur, et d'une éventuelle capacité présente à la sortie. Cette vitesse de charge est appelée vitesse de montée de l'amplificateur et est couramment désignée par le terme anglo-saxon "slew-rate".

Outre la plage de fonctionnement normal décrite ci-dessus, cet amplificateur comprend deux plages de fonctionnement exceptionnel :

- si les tensions V1 et V2 deviennent trop proches de la tension d'alimentation Vdd, les transistors T1b et T2b ne sont plus polarisés et deviennent inactifs, leurs courants de drain s'annulent, et les miroirs de courant M1b et M2b ne voient respectivement à leurs entrées que le courant I2 provenant du miroir M2a et le courant I1 provenant du miroir M1a ; l'amplificateur fournit alors en sortie un courant Is tel que :

$$Is = I1 - I2 = (V1 - V2)g_m(I_0) ;$$

- si les tensions V1 et V2 deviennent trop proches de la tension d'alimentation Vss, les transistors T1a et T2a deviennent inactifs et leurs courants de drain s'annulent ; les miroirs M1b et M2b ne reçoivent respectivement en entrée plus que le courant I2 provenant du transistor T1b et le courant I1 provenant du transistor T2b et le courant de sortie de l'amplificateur est dans ce cas aussi égal à I1-I2.

Dans ces deux plages de fonctionnement, la transconductance de l'amplificateur est égale à $g_m(I_0)$ et le courant de sortie maximal est $2I_0$.

Un inconvénient d'un tel amplificateur est donc la division par 2 de sa transconductance lors du passage de la plage de fonctionnement normal à l'une des plages de fonctionnement exceptionnel. Ainsi, si on souhaite une transconductance constante, le mode commun de l'amplificateur est limité à la plage de fonctionnement normal.

Le brevet américain 4 887 048 décrit un amplificateur à deux étages différentiels complémentaires ayant une transconductance constante sur toute la plage des tensions d'entrée. Pour obtenir oela, il comprend un commutateur destiné à rendre actif un seul des étages différentiels à la fois. Un inconvénient de cet amplificateur est qu'il ne peut pas être réalisé en technologie bipolaire.

Un objet de la présente invention définie dans les revendications est de prévoir un amplificateur à transconductance constante sur toute la plage des tensions d'entrée, qui soit réalisable aussi bien en technologie MOS qu'en technologie bipolaire.

Cet objet est atteint grâce à un amplificateur à transconductance comprenant : un premier amplificateur différentiel à couple de transistors d'un premier type, dont chacun est piloté par une de deux entrées, le courant de repos de ces transistors étant fixé à une valeur prédéterminée par une première source de courant reliée à une première tension d'alimentation ; un deuxième amplificateur différentiel à couple de transistors du type opposé au premier, dont chacun est piloté par une desdites entrées, le courant de repos de ces transistors étant fixé à ladite valeur prédéterminée par une deuxième source de courant reliée à une deuxième tension d'alimentation ; l'amplificateur à transconductance ayant une première plage de fonctionnement ou les deux amplificateurs différentiels sont actifs et des deuxième et troisième plages de fonctionnement ou un seul des amplificateurs différentiels est actif. Cet amplificateur à transconductance comprend des moyens pour dériver une fraction prédéterminée des courants fournis par les sources de courant aux amplificateurs différentiels, ces moyens étant actifs dans la première plage de fonctionnement et inactifs respectivement dans l'une des deuxième ou troisième plages et la fraction prédéterminée étant telle que la transconductance des transistors actifs dans l'une des deuxième ou troisième plages soit égale au double de la transconductance des transistors dans la première plage.

Selon un mode de réalisation de la présente invention, lesdits moyens comprennent : un troisième couple de transistors du type opposé, dont chacun est piloté par une desdites entrées, ces transistors étant disposés en parallèle entre la première source de courant et une troisième source de courant reliée à la deuxième tension d'alimentation ; et un quatrième couple de transistors du premier type, dont chacun est piloté par une desdites entrées, ces transistors étant disposés en parallèle entre la deuxième source de courant et une quatrième source de courant reliée à la première tension d'alimentation ; le courant fourni par chacune des troisième et quatrième sources de courant étant égal à ladite fraction prédéterminée.

Selon un mode de réalisation de la présente invention, ladite fraction prédéterminée est égale à 75 % du courant fourni par la première ou deuxième source de courant dans le cas où les transistors sont des transistors à effet de champ.

Selon un mode de réalisation de la présente invention, ladite fraction prédéterminée est égale à 50 % du courant fourni par la première ou deuxième source de courant dans le cas où les transistors sont des transistors bipolaires.

Selon un mode de réalisation de la présente invention, l'amplificateur à transconductance comprend : un premier miroir de courant dont l'entrée charge un des transistors du premier amplificateur différentiel ; un deuxième miroir de courant dont l'entrée charge l'autre transistor du premier amplificateur différentiel ; un troisième miroir de courant dont l'entrée charge un des transistors du deuxième amplificateur différentiel ; et un quatrième miroir de courant dont l'entrée charge l'autre des transistors du deuxième amplificateur différentiel ; la sortie du premier miroir étant reliée à l'entrée du quatrième, la sortie du troisième étant reliée à l'entrée du deuxième, et les sorties des deuxième et quatrième miroirs étant reliées l'une à l'autre et constituant la sortie de l'amplificateur.

Ces objets, caractéristiques et avantages ainsi que d'autres de la présente invention seront exposés plus en détail dans la description suivante de modes de réalisation particuliers faite en relation avec les figures jointes parmi lesquelles :

La figure 1, précédemment décrite, représente l'état de la technique ;
la figure 2 illustre un mode de réalisation de la présente invention ; et
la figure 3 illustre un amplificateur à transconductance utilisant le mode de réalisation de la figure 2.

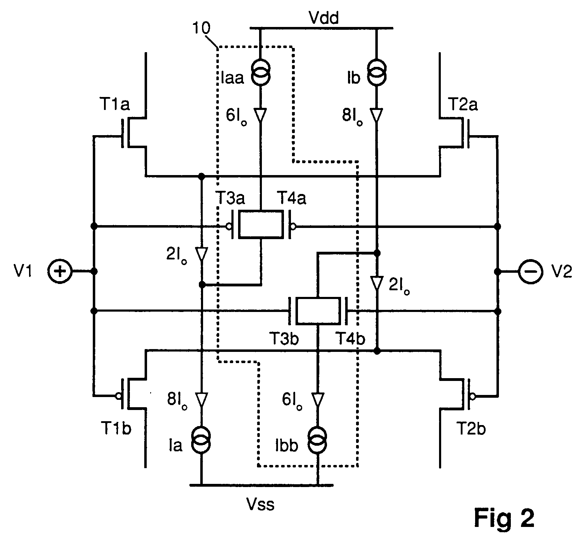

En figure 2, on retrouve les amplificateurs différentiels de la figure 1, à savoir les transistors T1a, T2a, T1b, T2b et les sources de courant Ia et Ib.

Les éléments additionnels du circuit selon la présente invention sont représentés à l'intérieur d'un cadre en pointilés 10. Ils permettent, dans la plage de fonctionnement exceptionnel où l'un des amplificateurs différentiels d'entrée est inactif, de doubler la transconductance des transistors de l'autre amplificateur différentiel d'où il résulte que la transconductance de l'amplificateur opérationnel dans son ensemble reste la même dans ses trois plages de fonctionnement.

Deux transistors T3a et T4a de mêmes caractéristiques que les transistors T1b et T2b sont disposés en parallèle entre une source de courant Iaa reliée à la tension d'alimentation Vdd et les sources des transistors T1a et T2a. Les grilles des transistors T3a et T4a sont respectivement reliées à l'entrée (+) et à l'entrée (-). Deux transistors T3b et T4b de mêmes caractéristiques que les transistors T1a et T2a sont disposés en parallèle entre une source de courant Ibb reliée à la tension d'alimentation Vss et les sources des transistors T1b et T2b. Les grilles des transistors T3b et T4b sont respectivement reliées à l'entrée (+) et à l'entrée (-). Ici, les sources de courant Ia et Ib fournissant chacune un courant de $8I_0$ au lieu de $2I_0$. Les sources de courant Iaa et Ibb fournissent chacune un courant $6I_0$.

Le fonctionnement du circuit selon la présente invention sera décrit dans le cadre de son association à l'amplificateur de la figure 1.

Dans la plage de fonctionnement normal, où les deux amplificateurs différentiels sont actifs, le couple de transistors T3a,T4a et le couple de transistors T3b,T4b sont passants. En conséquence, le courant $6I_0$ de chacune des sources de courant Iaa et Ibb se soustrait du courant $8I_0$ de chacune des sources de courant Ia et Ib. Il en résulte un courant de repos de $2I_0$ pour chacun des amplificateurs différentiels et on se retrouve dans les conditions de fonctionnement normal de l'amplificateur de la figure 1, qui présente une transconductance égale à $2g_m(I_0)$ et un courant de sortie maximal de $4I_0$.

Dans la plage de fonctionnement exceptionnel où les tensions V1 et V2 deviennent trop proches de la tension Vdd, les transistors T1b et T2b se bloquent mais aussi les transistors T3a et T4a qui sont pilotés de la même façon. Ainsi, le courant $6I_0$ qui circulait dans les transistors T3a et T4a n'est plus dérivé de la source de courant Ia et la totalité de son courant $8I_0$ est fournie aux sources des transistors T1a et T2a en fixant le courant de repos de chacun de ces transistors à $4I_0$. Le courant de repos des transistors T1a et T2a passe donc de $I_0$ à $4I_0$ et leur transconductance, qui est fonction du courant de repos, passe de $g_m(I_0)$ à $g_m(4I_0)$. Le courant de sortie, calculé de la même façon que pour la figure 1, vaut alors :

$$(V1-V2)g_m(4I_0).$$

Comme la transconductance $g_m$ d'un transistor MOS est proportionnelle à la racine carrée de son courant de repos, on a :

$$g_m(4I_0) = 2g_m(I_0).$$

Ainsi, dans cette plage de fonctionnement, le courant de sortie est égal à $2(V1-V2)g_m(I_0)$, comme dans le cas de la plage de fonctionnement normal précédemment décrite. La valeur maximale du courant de sortie est ici $8I_0$.

Dans la plage de fonctionnement exceptionnel où les tensions V1 et V2 deviennent trop proches de la tension Vss, le fonctionnement du circuit est symétrique, à savoir les transistors T1a, T2a, T3b, T4b se bloquent, le courant $6I_0$ qui circulait dans les transistors T3b et T4b n'est plus dérivé de la source Ib et la totalité du courant $8I_0$ de celle-ci est fournie aux sources des transistors T1b et T2b dont le courant de repos s'établit pour chacun à $4I_0$ au lieu de $I_0$. On aura de même, en sortie, un courant $2(V1-V2)g_m(I_0)$ et une valeur maximale de celui-ci de $8I_0$.

Ainsi, un amplificateur à transconductance muni du circuit selon la présente invention présente une transconductance constante pour un mode commun pouvant pratiquement atteindre les tensions d'alimentation Vdd et Vss.

Le courant de sortie maximal de cet amplificateur, et donc sa vitesse de montée, est doublé dans les plages de fonctionnement exceptionnel.

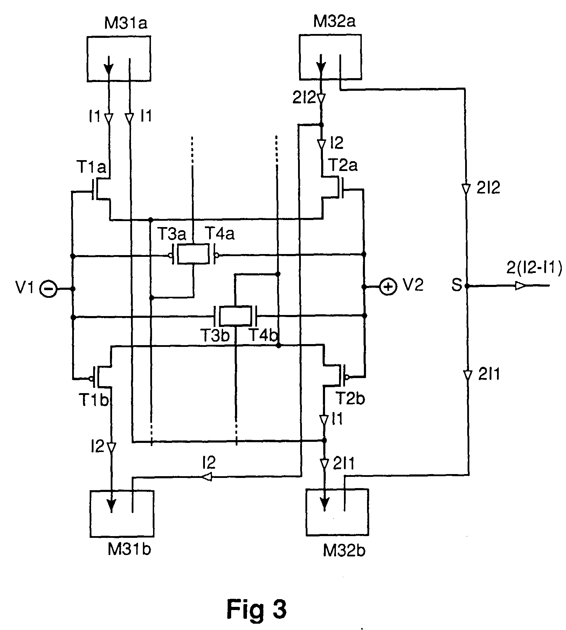

La figure 3 illustre schématiquement un mode de réalisation d'un amplificateur à transconductance muni du circuit de la présente invention et qui présente l'avantage de comprendre un miroir de courant de moins que le circuit de la figure 1.

On retrouve en figure 3 tous les éléments de la figure 2 mais les entrées (+) et (-) sont interverties. Les drains des transistors T1a et T2a sont respectivement reliés aux entrées de miroirs de courant M31a et M32a. Les drains des transistors T1b et T2b sont respectivement reliés aux entrées de miroirs de courant M31b et M32b. Les sorties des miroirs M32a et M32b sont reliées ensemble et constituent la sortie S de l'amplificateur. La sortie du miroir M31a est reliée au drain du transistor T2b et la sortie du miroir M31b est reliée au drain du transistor T2a.

Quand on applique une tension V1 à l'entrée (-) et une tension V2 à l'entrée (+) il s'établit un courant I1 dans les drains de chacun des transistors T1a et T2b et un courant I2 dans les drains de chacun des transistors T2a et T1b. Le courant de drain I1 du transistor T1a se retrouve en sortie du miroir M31a et vient s'ajouter au courant de drain I1 du transistor T2b. Ainsi le miroir M32b reçoit à son entrée un courant 2I1 que sa sortie draine de la sortie S de l'amplificateur. Le courant de drain I2 du transistor T1b se retrouve en sortie du miroir M31b et vient s'ajouter au courant de drain I2 du transistor T2a. Ainsi, le miroir M32a reçoit en entrée un courant 2I2 qui est délivré à la sortie de l'amplificateur. Le courant de sortie de l'amplificateur vaut :

$$2(I2-I1) = 2(V2-V1)g_m(I_0).$$

Lorsqu'un des amplificateurs différentiels est inactif, par exemple celui comprenant les transistors T1a et T2a, le miroir M32a ne voit à son entrée que le courant de sortie du miroir M31b et le miroir M32b ne voit à son entrée que le courant de drain du transistor T2b. Mais la valeur de ces courants a doublé car le circuit de la présente invention a permis de doubler la transconductance des transistors T1b et T2b, comme cela a été décrit pour la figure 2, et le courant de sortie reste inchangé par rapport au fonctionnement normal précédent.

Lorsque l'amplificateur différentiel comprenant les transistors T1b et T2b est inactif, le fonctionnement est symétrique.

Le circuit de la présente invention s'applique à tous les amplificateurs à transconductance comprenant une configuration d'entrée à deux amplificateurs différentiels complémentaires et permet à l'amplificateur de fonctionner avec une transconductance constante pour un mode commun variable pratiquement sur toute la plage comprise entre les deux tensions d'alimentation.

La présente invention a été décrite dans le cadre d'une obtention d'une tranconductance constante de l'amplificateur. Comme on l'a vu précédemment, le courant de sortie maximal était deux fois plus grand dans les plages de fonctionnement exceptionnel, ce qui entraînait une vitesse de montée deux fois plus grande dans ces plages. Si on désire une constance de cette vitesse de montée sur les trois plages plutôt qu'une constance de la transconductance, les courants de repos des transistors actifs dans les plages de fonctionnement exceptionnel seront doublés au lieu d'être quadruplés.

La présente invention a été décrite en relation avec des transistors MOS, mais elle s'applique telle quelle en technologie bipolaire sauf que les courants de repos des transistors actifs dans les plages de fonctionnement exceptionnel doivent être doublés au lieu d'être quadruplés. Dans ce cas, contrairement à la réalisation avec des transistors MOS, la transconductance de l'amplificateur ainsi que sa vitesse de montée sont constantes sur les trois plages de fonctionnement.

Pour doubler les courants de repos dans les plages de fonctionnement exceptionnel, on fixe les courants des sources de courant Ia et Ib à $4I_0$ et ceux des sources Iaa et Ibb à $2I_0$.

De nombreuses variantes et modifications de la présente invention apparaîtront à l'homme du métier, notamment il peut employer tout autre circuit permettant de détecter le non-fonctionnement des amplificateurs différentiels et de dériver un courant adéquat de celui fourni par les sources Ia et Ib.

**Revendications**

1. Amplificateur à transconductance comprenant :

   - un premier amplificateur différentiel à couple de transistors (T1a, T2a) d'un premier type et commandés respectivement par deux entrées, le courant de repos de ces transistors étant fixé à une valeur prédéterminée par une première source de courant (Ia) reliée à une première tension d'alimentation (Vss) ;

   - un deuxième amplificateur différentiel à couple de transistors (T1b, T2b) du type opposé au premier et commandés respectivement par lesdites deux entrées, le courant de repos de ces transistors étant fixé à ladite valeur prédéterminée par une deuxième source de courant (Ib) reliée à une deuxième tension d'alimentation (Vdd) ;

   - un étage de sortie (M1a-M3) pour produire un courant de sortie qui est une combinaison du courant d'au moins un des transistors du premier amplificateur différentiel et du courant d'au moins un des transistors du deuxième amplificateur différentiel ;

   l'amplificateur à transconductance ayant une plage de tensions d'entrée centrale où les deux amplificateurs différentiels sont actifs et des première et deuxième plages de tensions d'entrée extrêmes où un seul respectif des amplificateurs différentiels est actif ;

   caractérisé en ce qu'il comprend des moyens pour ajuster lesdites sources de courant de manière que la transconductance de l'amplificateur différentiel actif dans l'une ou l'autre des plages extrêmes soit égale au double de la transconductance de chacun des amplificateurs différentiels dans la plage centrale.

2. Amplificateur selon la revendication 1, caractérisé en ce que lesdits moyens comprennent :

   - un troisième couple de transistors (T3a,T4a) du type opposé, dont chacun est piloté par une desdites entrées, ces transistors étant disposés en parallèle entre la première source de courant (Ia) et une troisième source de courant (Iaa) reliée à la deuxième tension d'alimentation (Vdd) ; et

   - un quatrième couple de transistors (T3b,T4b) du premier type, dont chacun est piloté par une desdites entrées, ces transistors étant disposés en parallèle entre la deuxième source de courant (Ib) et une quatrième source de courant (Ibb) reliée à la première tension d'alimentation (Vss).

3. Amplificateur selon la revendication 2, caractérisé en ce que le courant de chacune des troisième et quatrième sources de courant est trois fois supérieur à celui de chacune des première et deuxième sources de courant dans le cas où les transistors sont des transistors à effet de champ.

4. Amplificateur selon la revendication 2, caractérisé en ce que le courant de chacune des troisième et quatrième sources de courant est égal à celui des première et deuxième sources de courant dans le cas où les transistors sont des transistors bipolaires.

5. Amplificateur selon la revendication 2, caractérisé en ce qu'il comprend :

- un premier miroir de courant (M31a) dont l'entrée charge un des transistors (T1a) du premier amplificateur différentiel ;
- un deuxième miroir de courant (M32a) dont l'entrée charge l'autre transistor (T2a) du premier amplificateur différentiel ;
- un troisième miroir de courant (M31b) dont l'entrée charge un des transistors (T1b) du deuxième amplificateur différentiel ; et
- un quatrième miroir de courant (M32b) dont l'entrée charge l'autre des transistors (T2b) du deuxième amplificateur différentiel ;

la sortie du premier miroir (M31a) étant reliée à l'entrée du quatrième (M32b), la sortie du troisième (M31b) étant reliée à l'entrée du deuxième (M32a), et les sorties des deuxième et quatrième miroirs étant reliées l'une à l'autre et constituant la sortie de l'amplificateur.

**Patentansprüche**

1. Transkonduktanz-Verstärker umfassend:

- einen ersten Differentialverstärker mit einem Transistorpaar (T1a, T2a) eines ersten Typs, die jeweils durch zwei Eingänge gesteuert sind, wobei der Ruhestrom dieser Transistoren auf einen Wert eingestellt ist, der durch eine mit einer ersten Speisespannung (Vss) verbundene erste Stromquelle (Ia) vorgegeben ist;

- einen zweiten Differentialverstärker mit einem Transistorpaar (T1b, T2b) von dem ersten Typ entgegengesetztem Typ, die jeweils durch die genannten zwei Eingänge gesteuert werden, wobei der Ruhestrom dieser Transistoren auf den genannten Wert eingestellt ist, der durch eine mit einer zweiten Speisespannung (Vdd) verbundene zweite Stromquelle (Ib) vorgegeben ist;

- eine Ausgangsstufe (M1a - M3) zur Erzeugung eines Ausgangsstroms, der eine Kombination des Stroms wenigstens eines der Transistoren des ersten Differentialverstärkers und des Stroms wenigstens eines der Transistoren des zweiten Differentialverstärkers ist;

- wobei der Transkonduktanz-Verstärker einen zentralen oder mittleren Bereich von Eingangsspannungen, in welchem die beiden Differentialverstärker aktiv sind, sowie einen ersten und einen zweiten Bereich von extremen Eingangsspannungen aufweist, in denen jeweils nur einer der Differentialverstärker aktiv ist;

dadurch gekennzeichnet, daß der Verstärker Mittel zur Einstellung der genannten Stromquellen aufweist derart, daß die Transkonduktanz des im einen oder im anderen der Extrembereiche aktiven Differentialverstärkers gleich dem Doppelten der Transkonduktanz jedes der Differentialverstärker im mittleren oder zentralen Bereich ist.

2. Verstärker nach Anspruch 1,
   dadurch gekennzeichnet, daß die genannten Mittel umfassen:

- ein drittes Transistorpaar (T3a, T4a) vom entgegengesetzten Typ, von denen jeder jeweils durch eine der genannten Eingangsgrößen gesteuert wird, wobei diese Transistoren parallel zueinander zwischen der ersten Stromquelle (Ia) und einer dritten Stromquelle (Iaa) angeordnet sind, die mit der zweiten Speisespannung (Vdd) verbunden sind; sowie

- ein viertes Transistorpaar (T3b, T4b) vom ersten Typ, von denen jeweils jeder durch eine der genannten Eingangsgrößen gesteuert ist, wobei diese Transistoren parallel zueinander zwischen der zweiten Stromquelle (Ib) und einer vierten Stromquelle (Ibb) angeordnet sind, die mit der ersten Speisespannung (Vss) verbunden ist.

3. Verstärker nach Anspruch 2,
   dadurch gekennzeichnet, daß im Falle, wo die Transistoren Feldeffekttransistoren sind, der Strom jeder der dritten und vierten Stromquelle dreifach größer als der Strom jeder der ersten und zweiten Stromquelle ist.

4. Verstärker nach Anspruch 2,
   dadurch gekennzeichnet, daß im Falle, wo die Transistoren Bipolar-Transistoren sind, der Strom jeder der dritten und vierten Stromquelle gleich dem Strom der ersten und der zweiten Stromquelle ist.

5. Verstärker nach Anspruch 2,
   dadurch gekennzeichnet, daß er umfaßt:

- einen ersten Stromspiegel (M31a), dessen Eingang einen der Transistoren (T1a) des ersten Differentialverstärkers lädt;

- einen zweiten Stromspiegel (M32a), dessen Eingang den anderen Transistor (T2a) des ersten Differentialverstärkers lädt;

- einen dritten Stromspiegel (M31b), dessen Eingang einen der Transistoren (T1b) des zweiten Differentialverstärkers lädt; und

- einen vierten Stromspiegel (M32b), dessen Eingang den anderen (T2b) der Transistoren des zweiten Differentialverstärkers lädt;

wobei der Ausgang des ersten Spiegels (M31a) mit dem Eingang des vierten (M32b) Stromspiegels, der Ausgang des dritten (M31b) mit dem Eingang des zweiten Stromspiegels (M32a) und die Ausgänge des zweiten und des vierten Stromspiegels miteinander verbunden sind und den Ausgang des Verstärkers bilden.

## Claims

1. A transconductance amplifier comprising:

   - a first differential amplifier with a pair of transistors (T1a, T2a) of a first type and respectively controlled by two inputs, the quiescent current of said transistors being fixed to a predetermined value by a first current source (Ia) connected to a first supply voltage (Vss);
   - a second differential amplifier with a pair of transistors (T1b, T2b) of a type opposite to that of the first and respectively controlled by said two inputs, the quiescent current of these transistors being fixed to said predetermined value by a second current source (Ib) connected to a second supply voltage (Vdd); an output stage (M1a-M3) for producing an output current, which is a combination of the current of at least one transistor of the first differential amplifier and of the current of at least one transistor of the second differential amplifier; the transconductance amplifier having a central range of input voltage where the two differential amplifiers are active and first and second extreme ranges of input voltages where only one respective differential amplifier is active;

   characterized in that it comprises means for adjusting said current sources so that the transconductance of the active differential amplifiers in one of the extreme ranges is equal to twice the transconductance of each differential amplifier in the central range.

2. An amplifier according to claim 1, characterized in that said means comprise:

   - a third pair of transistors (T3a, T4a) of the opposite type, each of which is controlled by one of said inputs, said transistors being arranged in parallel between the first current source (Ia) and a third current source (Iaa) connected to the second supply voltage (Vdd); and
   - a fourth pair of transistors (T3b, T4b) of the first type, each of which is controlled by one of said inputs, said transistors being arranged in parallel between the second current source (Ib) and a fourth current source (Ibb) connected to the first supply voltage (Vss).

3. An amplifier according to claim 2, characterized in that the current of each of the third and fourth sources is three times higher than the current provided by the first or second current source when the transistors are field effect transistors.

4. An amplifier according to claim 2, characterized in that the current of each of the third and fourth current sources is equal to the current provided by the first or second current source when the transistors are bipolar transistors.

5. An amplifier according to claim 2, characterized in that it comprises:

   - a first current mirror (M31a), the input of which loads one of the transistors (T1a) of the first differential amplifier;
   - a second current mirror (M32a), the input of which loads the other transistor (T2a) of the first differential amplifier;
   - a third current mirror (M31b), the input of which loads one of the transistors (T1b) of the second differential amplifier; and
   - a fourth current mirror (M32b), the input of which loads the other transistor (T2b) of the second differential amplifier;

   the output of said first mirror (M31a) being connected to the input of the fourth mirror (M32b), the output of the third mirror (M31b) being connected to the input of the second mirror (M32a), and the outputs of the second and fourth mirrors being interconnected and constituting the output of the amplifier.

Fig 1

**Fig 2**

**Fig 3**